# EUROPEAN PATENT SPECIFICATION

(11) **EP 0 512 376 B1**
(45) Date of publication and mention of the grant of the patent: **10.11.1999**
(21) Application number: 92107244.3
(22) Date of filing: 28.04.1992
(51) Int. Cl.: H03G 3/34, H03G 3/04

(54) **Plural time constant signal control**
Steuersignal mit Mehrfach-Zeitkonstanten
Signal de contrôle à constante de temps multiple

(30) Priority: 06.05.1991 US 696490
(43) Date of publication of application: 11.11.1992
(73) Proprietor: THOMSON CONSUMER ELECTRONICS, INC., Indianapolis Indiana 46201 (US)
(72) Inventor: Lendaro, Jeffrey Basil, Noblesville, Indiana (US)
(74) Representative: Einsel, Robert, Dipl.-Ing.

(56) References cited:
- EP-A- 0 208 530
- EP-A- 0 281 117
- DE-A- 2 917 100
- US-A- 3 916 321
- PATENT ABSTRACTS OF JAPAN, vol. 13, no. 410 (E-819), 11th September 1989; & JP-A-1 149 602 (MATSUSHITA ELECTRIC) 12-06-1989

## Description

### Background

The present invention relates to television receivers, and more particularly, to the processing of signals receiver by television or FM receiver, with particular application to audio signals.

For a more pleasing sound from a television receiver, it may be desirable to cause the level of a signal to increase slowly but still to have a quick decrease in level under some circumstances. This type of different rate signal change can be desirable during a power-up operation, following a channel change, or following a customer un-mute from a remote control so that a slow rise time takes the edge off the signal "attack". This is especially desirable when there is a channel chane with the new channel have a loud audio level. However, on a user mute when going into a cannel and just before set turn-off, the user expects a quick reduction of a audio level and may be disturbed if the lowering of the signal level takes too long. Accordingly, it is recognized herein that a signal control having a slow rate of change for increasing signals and a faster rate of change for decreasing signals is desirable for achieving these results.

An example of a receiver employing muting with two time constants is described by Morse in US patent 3,916,321 entitled "Noise suppression circuit" which issued 28 October 1975. The Morse apparatus comprising : (i) a delay circuit for effecting a delay in potential application and continued muting of the audio signal channel when a power on/off switch is initially closed: (ii) a first time-constant circuit to effect rapid potential discharge and muting of the audio signal channel when the power switch is opened; (iii) a second time-constant circuit and a functional switch for providing muting of the audio signal channel when changing receiver operating modes (e.g., when selecting FM, AM, phono, etc.). Audio control is provided by connecting a depletion mode FET in the shunt branch of an "L" type attenuator and varying the FET gate voltage by the delay circuit and the two time constant circuits and the functional switch. This system is relatively complex, it relies on transistor gain control characteristics (which may be difficult to match for stereo applications) and requires the addition of an attenuator in the audio signal path. Moreover, the time constants differ depending on whether muting is initiated by power switch operation or by the operation of the muting switch 47 when mode changing.

Another example of a muting arrangement is described by Schlegel in DE-A-29 17 100 entitled FADE-IN/FADE-OUT circuit for a LF AMPLIFIER which was laid open 30 October 1980. This arrangement provides fade-in and fade-out operation using a bipolar transistor in a shunt attenuator configuration in the audio channel and includes a double-time constant "active" integrator (comprising a DC voltage amplifier with capacitive feedback) for controlling the base-emitter voltage of the bipolar transistor. Control of the integrator is provided by a fade-in fade-out key which couples the amplifier input to ground or a DC voltage source via respective resistors which determine the fade-in and fade-out time constants. As in the example of Morse discussed above, this system is relatively complex, it relies on transistor gain control characteristics (which may be difficult to match for stereo applications) and requires the addition of an attenuator in the audio signal path. Also, the need for a DC amplifier in generating the transistor base-emitter control voltage adds to the cost and complexity of the circuit.

As used herein the term "signal" can be an audio signal, video composite signal, luminance signal, video composite signal, chroma signal, etc. even though the exemplary embodiment particularly discusses an audio signal.

### Summary of the invention

It is an object of the present invention to provide double time-constant signal level control of simplified design and improved accuracy and in which the functions of double time-constant muting and normal gain control are merged. Advantageously, signal level control in accordance with the invention does not require the addition of transistor shunt attenuators in the signal path, provides uniform time-constants for all muting modes, and avoids the need for DC amplifiers or extra turn-on delay circuits in control signal generation.

The principles of the present invention apply to apparatus for controlling signal level of a type comprising a source (IN) for providing an input signal having a level to be controlled, a signal level adjusting means (14) having an input coupled to the source for receiving the input signal, having an output (OUT) for providing a level controlled output signal and having a control terminal (16) for receiving a level control signal for controlling the level of the output signal; and control means (10, 18, 20, 22, 24) coupled to supply the control signal to the control terminal of the signal level adjusting means and including a first time constant circuit (18, 20) with relatively long time-constant and a second time-constant circuit (18, 22, 24) with a relatively shorter time-constant.

In present invention is characterized in that the signal level adjusting means comprises a voltage controlled amplifier (14); the control means comprises a digital-to-analog converter (10) having an output terminal (12) providing DC output signal having a DC level representative of a desired signal level of the level controlled output signal; the DC level having a voltage range which may vary continuously from a minimum value to a maximum value of the desired signal level during normal operation of the apparatus and which may step between said from one level to another during muting and un-muting modes of operation of the apparatus; and the DC output signal of the digital-to-analog converter is coupled to the control terminal of the control means via the first and second time-constant circuits such that all said steps in the DC level are subjected to smoothing with changes from a higher level to a lower level being more rapid than changes from the lower level to the higher level.

### Brief description of the drawings

Figure 1 shows part block diagram and part schematic representation of the circuit according to aspects of the present invention.

Figure 2 shows a graphic representation of a representative timing curves applicable when using aspects of the present invention shown in Figure 1.

### DETAILED DESCRIPTION OF THE PREFERRED EMBODIMENT

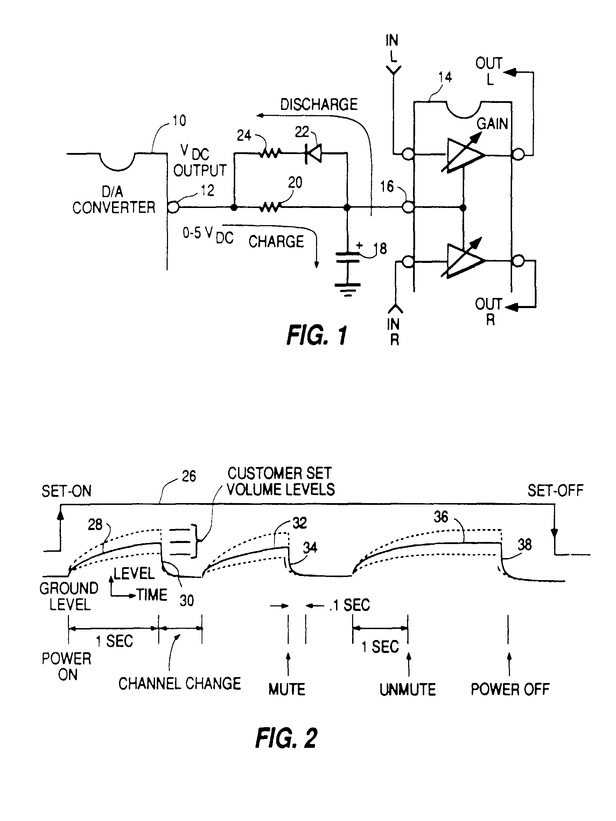

Referring now to Figure 1, there is shown a digital to analog converter (DAC) 10 providing an analog audio level control signal at terminal 12. In the exemplary embodiment, the audio control signal is derived from the microprocessor control IC in response to signals received from a remote control. The audio signal can be derived from a television source, FM source, CD disk player, or the like (not shown). If derived from a television source such as a broadcast station, satellite source, or cable television source, the audio signal is part of a composite signal which is detected in the usual way for providing a sound IF signal which is then detected to provide the audio signal. The derived audio signal is coupled to a gain controlled amplifier 14 for processing of the derived audio signal with the gain controlled by the control signal at the output pin 12 of DAC 10. Thus, the output signal at pin 12 is not the audio signal itself but the control signal for determining the level of the audio signal which, is subsequently coupled to power amplifiers and loudspeakers (not shown).

As explained above, it is desirable from a user satisfaction point of view, that the rates of change for the audio sound be different when changing from a lower level to a higher level of sound than when changing from a higher level of sound to a lower level. The gain of gain controlled amplifier 14 is adjustable in response to a control signal applied to pin 16. The volume level control signal at pin 12 is coupled to capacitor 18 through resistor 20 for establishing a first time constant with the voltage across capacitor 18 and at terminal 16 increasing at a first rate. For lowering the volume level, the discharge of capacitor 18 and the change of voltage at pin 16 is accomplished by discharge of capacitor 18 through diode 22 through the impedance present at terminal 12, which could be the output impedance of DAC 10 at terminal 12 and/or an external resistor coupled between terminal 12 and ground (not shown). Thus, upon a decrease in sound level, the voltage across capacitor 18 and at terminal 16 is changed at a second rate which is faster than the first rate. If the second rate is deemed to be too fast, it can be adjusted by coupling a resistor 24 in series with diode 22 for slowing the second rate while still keeping the second rate faster than the first rate of change.

As applied to an audio system, reference can be had to the timing and level diagrams of Figure 2 where it is shown that it is desirable to have a rapid decrease in sound level when certain operational changes are accomplished in the signal receiver. For example upon set power-on shown by diagram 26, the sound level is increased, as shown by curve 28, to one of various levels which were previously set by the user. Upon initiation of a change of channel, it may be desirable that the sound be rapidly decreased as shown by curve 30 thus effectively muting the sound during the change of channel. Once the channel has been selected, the sound will again be increased to a level as shown by curve 32. If a mute is initiated from a remote control or the like, the sound is rapidly lowered as shown by curve 34 and kept at that "off" level until the sound is un-muted wherein the sound increases in level as shown in curve 36 to the previous level. Upon the set being shut-off as shown by diagram 26, the sound is rapidly lowered as shown by curve 38 so that disruptions of operational status within the set during power-down do not cause audio transients which would be audible to the user.

## Claims

1. Apparatus for controlling signal level, comprising:
a source (IN) for providing an input signal having a level to be controlled;
signal level adjusting means (14) having an input coupled to said source for receiving said input signal, having an output (OUT) for providing a level controlled output signal and having a control terminal (16) for receiving a level control signal for controlling the level of said output signal;
control means (10, 18, 20, 22, 24) coupled to supply said control signal to said control terminal of said signal level adjusting means and including a first time constant circuit (18, 20) with a relatively long time-constant and a second time-constant circuit (18, 22, 24) with a relatively shorter time-constant;
**characterized in that:**
said signal level adjusting means comprises a voltage controlled amplifier (14);
said control means comprises a digital-to-analog converter (10) having an output terminal (12) providing DC output signal having a DC level representative of a desired signal level of said level controlled output signal;
said DC level having a voltage range which may vary continuously from a minimum value to a maximum value of said desired signal level during normal operation of said apparatus and which may step between from one level to another during muting and un-muting modes of operation of said apparatus;
said DC output signal of said digital-to-analog converter is coupled to said control terminal of said control means via said first and second time-constant circuits such that all said steps in said DC level are subjected to smoothing with changes from a higher level to a lower level being more rapid than changes from the lower level to the higher level.

2. Apparatus as recited in Claim 1 further characterized in that:
said first time-constant circuit comprises: a first resistor (20) coupled between said output (12) of said digital-to-analog converter (10) and said input (16) of said voltage controlled amplifier (14) and a capacitor (18) coupled between said control terminal of said voltage controlled amplifier and a point of reference potential; and
said second time-constant circuit comprises a series connected second resistor (24) and a diode (22) coupled in parallel with said first resistor.

## Patentansprüche

1. Vorrichtung zum Steuern eines Signalpegels, enthaltend:
eine Quelle (IN) für ein Eingangssignal mit einem zu steuernden Pegel,
Einstellmittel (14) für den Signalpegel mit einem mit der Quelle verbundenen Eingang zum Empfangen des Eingangssignals, mit einem Ausgang (OUT) für ein Ausgangssignal mit einem gesteuerten Pegel und mit einer Steuerklemme (16) zum Empfangen eines Signals für die Pegelsteuerung zum Steuern des Pegels des Ausgangssignals,
Steuermittel (10, 18, 20, 22, 24) zum Zuführen des Steuersignals zu der Steuerklemme der Einstellmittel für den Signalpegel und mit einer ersten Zeitkonstantenschaltung (18, 20) mit einer relativ langen Zeitkonstante und einer zweiten Zeitkonstantenschaltung (18, 22, 24) mit einer relativ kürzeren Zeitkonstante,
dadurch gekennzeichnet, daß
die Einstellmittel für den Signalpegel einen spannungsgesteuerten Verstärker (14) enthalten,
die Steuermittel einen Digital/Analog-Konverter (10) enthalten mit einer Ausgangsklemme (12) für ein Gleichspannungs-Ausgangssignal mit einem Gleichspannungspegel, der einen gewünschten Signalpegel des im Pegel gesteuerten Ausgangssignals darstellt,
daß der Gleichspannungspegel einen Spannungsbereich aufweist, der sich während des Normalbetriebs der Vorrichtung kontinuierlich von einem Minimalwert bis zu einem Maximalwert des gewünschten Signalpegels und sich stufenweise von einem Pegel zu einem anderen Pegel während des Stummschaltungs- und des Nicht-Stummschaltungs-Modus des Betriebs der Vorrichtung ändern kann,
daß das Gleichspannungs-Ausgangssignal des Digital/Analog-Konverters über die erste und die zweite Zeitkonstantenschaltung mit der Steuerklemme der Steuermittel derart verbunden ist, daß alle Stufen in dem Gleichspannungspegel einer Glättung bei Änderungen von einem hohen Pegel zu einem niedrigeren Pegel unterworfen sind, die schneller sind als Änderungen von dem niedrigen Pegel zu dem höheren Pegel.

2. Vorrichtung nach Anspruch 1, dadurch gekennzeichnet, daß
die erste Zeitkonstantenschaltung folgendes enthält:
einen ersten Widerstand (20) zwischen dem Ausgang (12) des Digital/Analog-Konverters (10) und dem Eingang (16) des spannungsgesteuerten Verstärkers (14) und einen Kondensator (18) zwischen der Steuerklemme des spannungsgesteuerten Verstärkers und einem Punkt mit einer Referenzspannung und
daß die zweite Zeitkonstantenschaltung eine Reihenschaltung eines zweiten Widerstands (24) und einer Diode (22) parallel zu dem ersten Widerstand enthält.

## Revendications

1. Appareil pour contrôler le niveau d'un signal, comprenant :
une source (IN) pour fournir un signal d'entrée ayant un niveau à contrôler ;
un moyen de réglage du niveau du signal (14) comportant une entrée couplée à ladite source pour recevoir ledit signal d'entrée, comportant une sortie (OUT) pour fournir un signal de sortie contrôlé en niveau et comportant une borne de commande (16) pour recevoir un signal de commande du niveau pour contrôler le niveau dudit signal de sortie ;
des moyens de commande (10, 18, 20, 22, 24) couplés pour alimenter ledit signal de commande à ladite borne de commande dudit moyen de réglage du niveau du signal et comportant un premier circuit à constante de temps (18, 20) avec une constante de temps relativement longue et un second circuit à constante de temps (18, 22, 24) avec une constante de temps relativement plus courte ;
caractérisé en ce que :
ledit moyen de réglage du niveau du signal comporte un amplificateur contrôlé en tension (14) ;
ledit moyen de commande comporte un convertisseur numérique- analogique (10) ayant une borne de sortie (12) fournissant un signal de sortie DC comportant un niveau DC représentant le niveau du signal souhaité dudit signal de sortie contrôlé en niveau ;
ledit niveau DC ayant une gamme de tension qui peut varier en continu à partir d'une valeur minimale vers une valeur maximale dudit niveau de signal souhaité durant un fonctionnement normal dudit appareil et qui peut varier par pas d'un niveau à un autre pendant les modes inactivés et non-inactivés de fonctionnement dudit appareil ;
ledit signal de sortie DC dudit convertisseur numérique - analogique est couplé à ladite borne de commande dudit moyen de commande à travers lesdits premier et second circuits à constante de temps de telle sorte que toutes les étapes dans les niveaux DC soient soumises à un lissage avec des modifications d'un niveau supérieur à un niveau inférieur plus rapides que les modifications d'un niveau inférieur vers un niveau supérieur.

2. Un appareil, comme mentionné dans la revendication 1, caractérisé de plus en ce que :
ledit premier circuit à constante de temps comporte une première résistance (20) couplée entre ladite sortie (12) dudit convertisseur numérique - analogique (10) et ladite entrée (16) dudit amplificateur contrôlé en tension (14) et une capacité (18) couplée entre ladite borne de commande dudit amplificateur contrôlé en tension et un point d'un potentiel de référence ; et en ce que
ledit second circuit à constante de temps comporte, connecté en séries, une seconde résistance (24) et une diode (22) couplées en parallèle avec ladite première résistance.
